Europäisches Patentamt

European Patent Office

Office européen des brevets

(19)

(11) **EP 1 325 175 B1**

(12) **EUROPÄISCHE PATENTSCHRIFT**

(45) Veröffentlichungstag und Bekanntmachung des Hinweises auf die Patenterteilung:
**04.05.2005 Patentblatt 2005/18**

(21) Anmeldenummer: **01969748.1**

(22) Anmeldetag: **20.09.2001**

(51) Int Cl.$^7$: **C25D 3/60**, C25D 3/58

(86) Internationale Anmeldenummer:
**PCT/EP2001/010907**

(87) Internationale Veröffentlichungsnummer:
**WO 2002/024979 (28.03.2002 Gazette 2002/12)**

(54) **ELEKTROLYT UND VERFAHREN ZUR ABSCHEIDUNG VON ZINN-KUPFER-LEGIERUNGSSCHICHTEN**

ELECTROLYTE AND METHOD FOR DEPOSITING TIN-COPPER ALLOY LAYERS

ELECTROLYTE ET PROCEDE POUR DEPOSER DES COUCHES D'ALLIAGES ETAIN-CUIVRE

(84) Benannte Vertragsstaaten:
**DE FR GB IT SE**

(30) Priorität: **20.09.2000 DE 10046600**
**29.11.2000 DE 10059139**

(43) Veröffentlichungstag der Anmeldung:
**09.07.2003 Patentblatt 2003/28**

(73) Patentinhaber: **Dr.Ing. Max Schlötter GmbH & Co. KG**
**73312 Geislingen/Steige (DE)**

(72) Erfinder:
• **DIETTERLE, Michael**
**73433 Aalen (DE)**
• **JORDAN, Manfred**
**73084 Salach (DE)**
• **STRUBE, Gernot**
**73312 Geislingen (DE)**

(74) Vertreter: **HOFFMANN - EITLE**
**Patent- und Rechtsanwälte**
**Arabellastrasse 4**
**81925 München (DE)**

(56) Entgegenhaltungen:
**EP-A- 0 854 206          DE-A- 4 338 148**
**DE-C- 19 852 219         JP-A- 2001 234 387**
**US-A- 4 389 286          US-A- 4 490 220**
**US-A- 5 417 841          US-A- 5 863 410**

• **PATENT ABSTRACTS OF JAPAN vol. 2000, no. 14, 5. März 2001 (2001-03-05) & JP 2000 328286 A (YUKEN KOGYO KK), 28. November 2000 (2000-11-28)**
• **PATENT ABSTRACTS OF JAPAN vol. 2000, no. 23, 10. Februar 2001 (2001-02-10) & JP 2001 164396 A (ISHIHARA CHEM CO LTD;DAIWA KASEI KENKYUSHO:KK), 19. Juni 2001 (2001-06-19) -& CHEMICAL ABSTRACTS, vol. 135, Columbus, Ohio, US; abstract no. 52718, XP002185247**
• **PATENT ABSTRACTS OF JAPAN vol. 1996, no. 05, 31. Mai 1996 (1996-05-31) & JP 08 013185 A (EBARA YUUJIRAITO KK), 16. Januar 1996 (1996-01-16)**

**Beschreibung**

Die vorliegende Erfindung betrifft einen sauren Elektrolyten zur Abscheidung von Zinn-Kupfer-Legierungen, ein Verfahren, das diesen Elektrolyten einsetzt, und die Verwendung des Elektrolyten zur Beschichtung elektronischer Bauteile.

In der Fertigung elektronischer Baugruppen ist das Weichlöten unter Verwendung der eutektischen Lotlegierung SnPb (63 Gew.% Sn 37 Gew.% Pb) das Standardverfahren der Verbindungstechnik. Abgestimmt darauf ist es üblich, zur Erhaltung der Lötbarkeit der zu verbindenden Komponenten diese durch galvanische Prozesse mit einer Bleizinnschicht zu versehen. Die Bleizinnschichten können im Prinzip eine beliebige Legierungszusammensetzung aufweisen, ebenso sind die reinen Metalle einsetzbar. Am häufigsten werden Legierungen mit 3 bis 40 Gew.% Pb, insbesondere 5 bis 20 Gew.% Pb, verwendet. Hochbleihaltige Legierungen mit z.B. 95 Gew.% Pb werden für Spezialanwendungen eingesetzt, wenn höhere Schmelztemperaturen erwünscht sind. Beschichtungen mit Reinzinn sind ebenfalls weit verbreitet, obwohl hier prinzipielle Probleme wegen der nicht auszuschließenden Gefahr der Whiskerbildung bestehen.

Obwohl die genannten Bleizinnlegierungen sehr gute Eigenschaften beim Weichlöten zeigen, besteht ein sehr großes Bestreben nach einer Substitution von Blei. Bei einer Verschrottung und Deponierung von Ausrüstungsgegenständen mit bleihaltigen Lötstellen besteht die Gefahr, dass durch Korrosionsvorgänge Blei in wasserlösliche Form überführt werden kann. Dadurch kann es langfristig zu einer entsprechenden Verunreinigung des Grundwassers kommen.

Eine aussichtsreiche Alternative für das eutektische Bleizinnlot ist die Legierung Zinn-Silber-Kupfer. Auch hier wird zweckmäßigerweise die eutektische Zusammensetzung verwendet, da diese die Absenkung der Verarbeitungstemperaturen auf ein Minimum ermöglicht. Zu hohe Verarbeitungstemperaturen können z.B. beim Weichlöten von Leiterplatten und Komponenten elektronischer Baugruppen zu einer irreversiblen Schädigung führen. Die eutektische Zusammensetzung der Zinn-Silber-Kupfer-Legierung besteht aus 95,5 Gew.% Zinn, 3,8 Gew.% Silber und 0,7 Gew.% Kupfer. Der Schmelzpunkt des Eutektikums beträgt 217°C.

Im Fall der Verwendung des Zinn-Silber-Kupfer-Lotes ist es wünschenswert, dass die Bauteile zur Erhaltung der Lötbarkeit galvanisch mit Überzügen eines oder mehrerer Bestandteile des Lotes beschichtet sind. Eine Beschichtung mit Reinzinn ist wegen der bereits erwähnten Gefahr der Whiskerbildung weniger erwünscht. Beschichtungen mit reinem Silber und Zinn-Silber-Legierungsbeschichtungen können aus Kostengründen unvorteilhaft sein. Überzüge aus reinem Kupfer sind nicht geeignet, da durch die Bildung einer Oxidschicht auf der Kupferoberfläche ("Anlaufen") das Lötverhalten stark beeinträchtigt wird. Die Verwendung einer Zinn-Kupfer-Beschichtung wäre daher wünschenswert. Der Kupferanteil der Zinn-Kupfer-Beschichtung sollte sich bevorzugt nicht wesentlich vom Kupferanteil der eutektischen Legierung unterscheiden, um die Lötbarkeit der Beschichtung bei möglichst niedrigen Temperaturen zu ermöglichen.

Eine weitere aussichtsreiche Alternative für das eutektische Bleizinnlot ist die Legierung Zinn-Kupfer. Auch hier wird wieder zweckmäßigerweise die eutektische Zusammensetzung verwendet, da diese die Absenkung der Verarbeitungstemperaturen auf ein Minimum ermöglicht. Die eutektische Zusammensetzung der Zinn-Kupfer-Legierung besteht aus 99,3 Gew.% Sn und 0,7 Gew.% Cu. Neben der eutektischen Zusammensetzung können ebenfalls Zinn-Kupfer-Legierungen mit einem etwas höheren Kupferanteil (z.B. 3 Gew.% Kupfer) Anwendung finden, da ein höherer Kupferanteil eine Verringerung der Whiskerbildung bewirken kann.

Im Falle der Verwendung eines Zinn-Kupfer-Lotes ist es wiederum wünschenswert, dass die zu verbindenden Bauteile zur Erhaltung der Lötbarkeit galvanisch mit Überzügen einer Zinn-Kupfer-Legierung beschichtet sind.

Die elektrolytische Abscheidung von Kupfer-Zinn-Legierungen mit Kupferanteilen von ca. 80-90 Gew.% (Rotbronze) oder 45-60 Gew.% Cu (Speculum) ist in der Praxis bekannt. Diese Legierungen werden aus alkalischen Lösungen, die Zinn als .Stannat und Kupfer in Form des Cyanidkomplexes $Cu(CN)_2^{(-)}$ enthalten, abgeschieden.

Alkalische Elektrolyte sind mit dem Nachteil verbunden, dass das Zinn im alkalischen Milieu als Stannat, d. h. in vierwertiger Form vorliegt. Dadurch ist die Abscheidegeschwindigkeit im Vergleich zu einem Sn(II) enthaltenden sauren Elektrolyten um 50% verringert.

Zusätzlich stellt die Verwendung der hochtoxischen Kupfercyanidkomplexe eine Gefahr für das mit den alkalischen Elektrolyten arbeitende Personal dar. Außerdem müssen die Abwässer solcher Elektrolyte zur Vermeidung von Umweltbelastungen einer aufwendigen Behandlung zur Entfernung der Cyanidionen unterzogen werden.

Weiterhin sollten die bestehenden Anlagen, die bisher zur Beschichtung mit Zinn-Blei-Legierungen aus sauren Elektrolyten eingesetzt wurden, auch für die Abscheidung der Zinn-Kupfer-Beschichtungen einsetzbar sein. Da alkalische Elektrolyte z.B. keramische Bestandteile von Bauteilen der bestehenden Anlagen angreifen können, ist der Einsatz saurer Zinn-Kupfer-Elektrolyte erwünscht.

Aus diesen Gründen ist es bevorzugt, dass die elektrolytische Abscheidung von Zinn-Kupfer-Legierungen aus sauren Elektrolyten erfolgen kann, die zweiwertiges Zinn und kein Cyanid enthalten.

Das zweiwertige Zinn kann in sauren Elektrolyten sehr leicht zur vierwertigen Stufe oxidiert werden. In dieser Form ist es aus sauren Elektrolyten nicht mehr elektrolytisch abscheidbar und somit dem Prozess entzogen. Die Oxidation zur vierwertigen Stufe ist außerdem mit einer starken Schlammbildung verbunden, die das Betreiben solcher Elektrolyte erschweren kann.

Aus diesem Grund ist es im Stand der Technik üblich, zur Verhinderung der Oxidation der zweiwertigen Zinnionen geeignete Oxidationsstabilisatoren zuzusetzen. Typische Verbindungen sind z.B. Mono- oder Polyhydroxyphenylverbindungen wie Brenzcatechin, Hydrochinon oder Phenolsulfonsäure. Diese Verbindungen sind in der Literatur eingehend beschrieben (z.B. Manfred Jordan: Die elektrolytische Abscheidung von Zinn und Zinnlegierungen, Eugen G. Leuze-Verlag 1993, Seite 83).

Die Zinn(II)oxidation wird durch Kupferionen katalytisch beschleunigt. Das zweiwertige Zinn kann Kupfer zur Stufe des einwertigen Kupfers reduzieren. Das einwertige Kupfer wird durch Luftsauerstoff wieder zur zweiwertigen Form rückoxidiert. Als Zwischenprodukt wird dabei Wasserstoffperoxid gebildet. Die folgenden Reaktionsgleichungen stellen die genannten Reaktionen dar:

$$Sn^{2+} + 2Cu^{2+} \rightarrow Sn^{4+} + 2Cu^{+}$$

$$2Cu^{+} + 2H^{+} + O_2 \rightarrow 2Cu^{2+} + H_2O_2$$

Dieser Reaktionsmechanismus ist von W. M. Murray und N. H. Furman (J. Am. Chem. Soc. 58 (1936) 1843) beschrieben worden.

Für die Abscheidung von Zinn-Kupfer-Legierungen mit einem Kupferanteil von bis zu 10 Gew.% sind Kupferkonzentrationen von bis zu 5 g/l, abhängig vom Zinngehalt des Elektrolyten, erforderlich. Diese hohen Kupferkonzentrationen bewirken so hohe Oxidationsgeschwindigkeiten des zweiwertigen Zinns, dass eine stabile Arbeitsweise des sauren Elektrolyten nicht gegeben ist. Die Oxidation des Zinn(II) kann in Gegenwart von Kupfer auch durch höhere Zugaben der im Stand der Technik bekannten Antioxidantien nicht verhindert werden.

Ein weiteres Problem bei der Entwicklung eines sauren Elektrolyten zur Abscheidung von Zinn-Kupfer-Legierungen mit einem geringen Kupferanteil besteht in der relativ großen Potentialdifferenz zwischen den Metallen Zinn und Kupfer. Die Standardpotentiale betragen:

$$Sn^{2+} + 2e \rightarrow Sn^{0} : \quad -0,12\ V$$

$$Cu^{2+} + 2e \rightarrow Cu^{0} : \quad +0,35\ V$$

Ist in einem Elektrolyten, der zwei abscheidbare Metalle enthält, die Potentialdifferenz der beiden Metalle groß, wird zum einen bevorzugt das Metall mit dem positiveren Standardpotential abgeschieden. Das heißt, aus einem Zinn-Kupfer-Elektrolyten wird bevorzugt Kupfer abgeschieden.

Weiterhin bewirkt der Potentialunterschied, dass die elektrochemisch edlere Komponente Kupfer im Ladungsaustausch auf den in Verfahren zur elektrolytischen Abscheidung von Zinnlegierungen im allgemeinen eingesetzten Zinnanoden abgeschieden wird. Durch diese Reaktion können die Zinnanoden passiviert werden. Solche passivierten Zinnanoden ermöglichen keinen Stromdurchgang mehr und verhindern eine elektrolytische Metallabscheidung.

Außerdem führt die Abscheidung von Kupfer auf den Anoden dazu, dass die Konzentration der Kupferionen im Elektrolyten abnimmt. Um jedoch eine Beschichtung mit einem bestimmten Kupfergehalt zu erhalten, sollte die Kupferionenkonzentration im Elektrolyten möglichst konstant sein.

Voraussetzung für eine erfolgreiche Abscheidung von Zinn-Kupfer-Legierungen mit einem bestimmten Kupfergehalt aus einem sauren, zweiwertige Zinnionen enthaltenden Elektrolyten ist es daher, geeignete Verbindungen zu finden, die eine Komplexierung des Kupfers und dadurch eine Verschiebung des Standardpotentials des Kupfers zu negativeren Werten bewirken, so dass die gewünschte Kupferionenkonzentration im Elektrolyten aufrechterhalten werden kann. Außerdem müssen die Komplexbildner selektiv auf Kupfer wirken. Bei gleichzeitiger Komplexierung von Zinn würde auch hier eine Verschiebung des Standardpotentials zu negativeren Werten erfolgen. Die ursprüngliche Potentialdifferenz der unkomplexierten Ionen wäre dadurch wieder hergestellt.

Aufgabe der vorliegenden Erfindung ist es somit, einen Elektrolyten zur Abscheidung von Zinn-Kupfer-Legierungen zur Verfügung zu stellen, der für den Einsatz in bestehenden Anlagen, die bisher zur Abscheidung der standardmäßigen Blei-Zinn-Schichten verwendet werden, geeignet ist, der nicht zu einer Passivierung der Anoden durch Abscheidung von Kupfer auf den Anoden führt und mit dem Zinn-Kupfer-Beschichtungen einer gewünschten Zusammensetzung erhältlich sind.

Weiterhin sollte der Elektrolyt gegenüber der durch Kupfer(II)ionen katalysierten Oxidation der Zinn(II)ionen und gegenüber Schlammbildung stabil sein, so dass ein über einen langen Zeitraum einsetzbarer Elektrolyt erhalten wird. Er sollte sowohl bei niedrigen kathodischen Stromdichten (Trommel- oder Gestelltechnik) als auch bei hohen kathodischen Stromdichten (Durchlauf-Galvanisier-Verfahren) eingesetzt werden können und nicht toxisch sein, insbesondere die Abwasserbehandlung nicht erschweren, d.h. keine Umweltbeeinträchigung darstellen.

Die Aufgabe wird durch einen sauren wässrigen Elektrolyten zur Abscheidung von Zinn-Kupfer-Legierungen gelöst, der eine oder mehrere Alkyl- oder Alkanolsulfonsäuren, ein oder mehrere lösliche Zinn(II)salze, ein oder mehrere lösliche Kupfer(II)salze und ein oder mehrere organische Schwefelverbindungen umfasst, wobei die organischen Schwefelverbindungen als Strukturmerkmal eine oder mehrere Thioetherfunktionen und/oder Etherfunktionen der allgemeinen Formel -R-Z-R'- enthalten, wobei R und R' gleiche oder verschiedene nichtaromatische organische Reste und Z ein Schwefelatom oder ein Sauerstoffatom darstellen, unter der Voraussetzung, dass mindestens einer der Reste R und R' mindestens ein Schwefelatom enthält, wenn Z ausschließlich ein Sauerstoffatom ist.

Die organischen Schwefelverbindungen weisen bevorzugt die folgende allgemeine Formel auf:

$$X-R^1-[Z-R^2]_n-Z-R^3-Y \tag{I}$$

worin n = 0 bis 20, bevorzugt 0 bis 10, besonders bevorzugt 0 bis 5, ist, X und Y unabhängig voneinander jeweils -OH, -SH oder -H sind, Z jeweils ein Schwefelatom oder ein Sauerstoffatom darstellt und die Reste Z im Fall $n \geq 1$ in Formel (I) jeweils gleich oder verschieden sind, $R^1$, $R^2$ und $R^3$ unabhängig voneinander jeweils eine gegebenenfalls substituierte lineare oder verzweigte Alkylengruppe darstellen und die Reste $R^2$ im Fall n > 1 in Formel (I) jeweils gleich oder verschieden sind. Unter der Voraussetzung, dass Z ausschließlich ein Sauerstoffatom ist, enthält mindestens einer der Reste X, Y, $R^1$, $R^2$ und $R^3$ mindestens ein Schwefelatom.

Beispiele für Alkylengruppen sind Alkylengruppen mit 1 bis 10, bevorzugt 1 bis 5, Kohlenstoffatomen, z.B. Methylen-, Ethylen-, n-Propylen-, iso-Propylen-, n-Butylen-, iso-Butylen- und tert-Butylengruppen. Beispiele der Substituenten der Alkylengruppen sind -OH, -SH, -SR$^4$, worin $R^4$ eine Alkylgruppe mit 1 bis 10 Kohlenstoffatomen, z.B. eine Methyl-, Ethyl-, n-Propyl- oder iso-Propylgruppe, ist, -OR$^4$, -NH$_2$, NHR$^4$ und NR$^4_2$ (wobei die beiden Substituenten R$^4$ gleich oder verschieden sein können).

Im Fall, dass Z in Formel (I) ausschließlich ein Sauerstoffatom darstellt, können die schwefelhaltigen Reste X und/oder Y eine SH-Gruppe sein und/oder die schwefelhaltigen Reste $R^1$, $R^2$ und/oder $R^3$ können z.B. einen Alkylenrest darstellen, der mit einer SH-Gruppe oder mit einer SR$^4$-Gruppe substituiert ist.

Bevorzugt sind in Formel (I) $n \geq 1$, $R^1$, $R^2$ und $R^3$ unabhängig voneinander eine Alkylengruppe, die mindestens zwei Kohlenstoffatome aufweist, und für den Fall, dass nur ein Z ein Schwefelatom darstellt, ist X und/oder Y eine SH-Gruppe und für den Fall, dass Z ausschließlich ein Sauerstoffatom ist, stellen X und Y eine SH-Gruppe dar.

Weiterhin sind die folgenden organischen Schwefelverbindungen bevorzugt:

Bis-(hydroxyethyl)-sulfid:

$$HO-CH_2-CH_2-S-CH_2-CH_2-OH$$

3,6-Dithiaoctandiol-1,8:

$$HO-CH_2-CH_2-S-CH_2-CH_2-S-CH_2-CH_2-OH$$

3,6-Dioxaoctandithiol-1,8:

$$HS-CH_2-CH_2-O-CH_2-CH_2-O-CH_2-CH_2-SH$$

3,6-Dithia-1,8-dimethyloctan*diol*-1,8:

$$HO-CH(CH_3)-CH_2-S-CH_2-CH_2-S-CH_2-CH(CH_3)-OH$$

4,7-Dithiadecan:

$$H_3C-CH_2-CH_2-S-CH_2-CH_2-S-CH_2-CH_2-CH_3$$

3,6-Dithiaoctan:

$$H_3C-CH_2-S-CH_2-CH_2-S-CH_2-CH_3$$

3,6-Dithiaoctandithiol-1,8:

$$HS-CH_2-CH_2-S-CH_2-CH_2-S-CH_2-CH_2-SH$$

Das Molverhältnis der organischen Schwefelverbindung zum löslichen Kupfer(II)salz (molare Menge organische Schwefelverbindung : molare Menge lösliches Kupfer(II)salz) beträgt bevorzugt mindestens 2:1, besonders bevorzugt mindestens 3:1, insbesondere bevorzugt 20:1 bis 3:1.

Das Zinn(II) kann im Elektrolyten als Salz von Mineral-, Alkylsulfon- oder Alkanolsulfonsäuren vorliegen. Beispiele für Salze der Mineralsäuren sind Sulfate und Tetrafluoroborate. Bevorzugte Salze der Alkylsulfonsäuren sind z. B. Methansulfonate, Ethansulfonate, n- und iso-Propansulfonate, Methandisulfonate, Ethandisulfonate, 2,3-Propandisulfonate und 1,3-Propandisulfonate. Einsetzbare Alkanolsulfonate sind 2-Hydroxyethansulfonate, 2-Hydroxypropansulfonate und 3-Hydroxypropansulfonate. Besonders bevorzugt ist Zinn(II)methansulfonat.

Die Zinn(II)salze sind im Elektrolyten bevorzugt in einer Menge von 5 bis 200 g/l Elektrolyt, besonders bevorzugt 10 bis 100 g/l Elektrolyt, berechnet als Zinn(II), vorhanden.

Das Kupfer(II) liegt im Elektrolyten bevorzugt in Form der Salze von Mineral-, Alkylsulfon- oder Alkanolsulfonsäuren vor. Beispiele für Mineral-, Alkylsulfon- oder Alkanolsulfonsäuresalze entsprechen den oben für die Zinn(II) salze genannten Verbindungen. Besonders bevorzugt ist Kupfer(II)methansulfonat.

Im Elektrolyten sind bevorzugt 0,05 bis 50 g/l Elektrolyt, besonders bevorzugt 0,1 bis 20 g/l Elektrolyt, Kupfer (II)salze, berechnet als Kupfer(II), vorhanden.

Die löslichen Kupfersalze können beim Ansetzen des Elektrolyten erzeugt werden, indem Kupferverbindungen zugegeben werden, die sich im sauren Bereich unter Salzbildung auflösen. Beispiele für Kupferverbindungen, die sich im sauren Bereich unter Salzbildung auflösen, sind Kupferoxid (CuO), Kupfercarbonat (CuCO$_3$) und lösliches Kupfercarbonat (Cu$_2$(OH)$_2$CO$_3$).

Im Elektrolyten können weiterhin herkömmliche Antioxidationsmittel, z.B. Mono- oder Polyhydroxyphenylverbindungen wie Brenzcatechin, Hydrochinon oder Phenolsulfonsäure, vorliegen. Die Konzentration dieser Antioxidationsmittel kann 0,05 bis 10 g/l Elektrolyt betragen.

Der Elektrolyt kann außerdem verschiedene Zusätze, die üblicherweise in sauren Elektrolyten zur Abscheidung von Zinnlegierungen eingesetzt werden, z.B. kornverfeinernde Zusätze, Netzmittel und/oder Glanzbildner, enthalten.

Als kornverfeinernde Zusätze können z.B. nichtionogene Tenside der allgemeinen Formel RO-(CH$_2$-CH$_2$-O)$_n$-H, worin R eine Alkyl-, Aryl-, Alkaryl- oder Aralkylgruppe mit 1 bis 20, bevorzugt 1 bis 15, Kohlenstoffatomen darstellt und n = 1 bis 20 ist, vorliegen.

Der kornverfeinernde Zusatz liegt bevorzugt in einer Menge von 0,1 bis 50 g/l Elektrolyt, bevorzugt 1 bis 10 g/l Elektrolyt, vor.

Das Netzmittel kann in einer Menge von 0,1 bis 50 g/l Elektrolyt, vorzugsweise 0,5 bis 10 g/l Elektrolyt vorliegen.

Die Alkylsulfonsäure und die Alkanolsulfonsäure weisen bevorzugt 1 bis 10, besonders bevorzugt 1 bis 5, Kohlenstoffatome auf. Als Alkylsulfonsäuren können z.B. Methansulfonsäure, Ethansulfonsäure n-Propansulfonsäure, isoPropansulfonsäure, Methandisulfonsäure, Ethandisulfonsäure, 2,3-Propandisulfonsäure oder 1,3-Propandisulfonsäure eingesetzt werden. Einsetzbare Alkanolsulfonsäuren sind z.B. 2-Hydroxyethansulfonsäure, 2-Hydroxypropansulfonsäure und 3-Hydroxypropansulfonsäure.

Die Alkyl- und/oder Alkanolsulfonsäure liegt im Elektrolyten bevorzugt in einer Konzentration von 50 bis 300 g/l Elektrolyt, besonders bevorzugt 100 bis 200 g/l Elektrolyt vor.

Der pH des sauren Elektrolyten beträgt vorzugsweise 0 bis < 1.

Mit der vorliegenden Erfindung wird weiterhin ein Verfahren zur elektrolytischen Beschichtung von Substraten mit Zinn-Kupfer-Legierungen, in dem unter Einsatz des erfindungsgemäßen Elektrolyten, einer Anode aus metallischem Zinn und einer Kathode aus dem zu beschichtenden Substrat die Beschichtung unter Durchleiten von Gleichstrom aufgebracht wird, zur Verfügung gestellt.

Die mit diesem Verfahren aufgebrachten Zinn-Kupfer-Legierungen können Kupfer in einem Anteil von 0,1 bis 99,9 Gew.% enthalten. Um die Lötbarkeit der Legierungen bei niedrigen Temperaturen zu ermöglichen, weisen sie bevorzugt einen Kupferanteil von 0,5 bis 10 Gew.%, besonders bevorzugt 2 bis 5 Gew.%, auf. Der Kupferanteil kann z.B. durch Variation der Konzentrationsverhältnisse der Zinn- und Kupfersalze im Elektrolyten, der Elektrolyttemperatur und der Strömungsgeschwindigkeit des Elektrolyten, bezogen auf das zu beschichtende Material, eingestellt werden.

Die Stromdichte kann 0,1 A/dm$^2$ (Trommel- oder Gestelltechnik) bis 100 A/dm$^2$ (Hochgeschwindigkeitsanlagen) betragen.

Die Temperatur des Elektrolyten liegt bevorzugt im Bereich von 0 bis 70 °C, besonders bevorzugt im Bereich von 20 bis 50°C.

Als zu beschichtendes Substrat können alle üblichen Materialien, die zur Herstellung elektronischer Bauteile verwendet werden, vorliegen. Beispiele sind Kupfer oder Kupferlegierungen, Nickel-Eisen-Legierungen (z.B. Alloy 42), vernickelte Oberflächen und ähnliche Materialien.

Der erfindungsgemäße Elektrolyt kann für die Beschichtung von elektronischen Bauteilen Verwendung finden.

Die vorliegende Erfindung wird anhand der nachfolgenden Ausführungsbeispiele erläutert.

Beispiel 1

Ein Zinn-Kupfer-Elektrolyt wurde wie folgt angesetzt:

| | |
|---|---|
| 150 g/l | 70 %ige wässrige Methansulfonsäure |
| 20 g/l | Zinn(II), als Zinnmethansulfonat |
| 0,5 g/l | Kupfer (II), als Kupfermethansulfonat |
| 6 g/l | 3, 6-Dithiaoctandiol-1, 8 |
| 4 g/l | Nonylphenolethoxilat mit 14 EO-Gruppen (Lutensol AP-14 der Fa. BASF) |

Mit diesem Elektrolyten wurden Kupferbleche in der Gestelltechnik bei einer Stromdichte von 0,5-2 A/dm$^2$ beschichtet. Die Elektrolyttemperatur betrug 20 ± 2°C. Der Elektrolyt wies einen pH von 0 auf. Es wurden feinkristalline helle, seidenglänzende Schichten ohne Anzeichen von Dendritbildung erhalten.

Beispiel 2

Der folgende Zinn-Kupfer-Elektrolyt wurde angesetzt:

| | |
|---|---|
| 150 g/l | 70 %ige wässrige Methansulfonsäure |
| 40 g/l | Zinn(II), als Zinnmethansulfonat |
| 1 g/l | Kupfer(II), als Kupfermethansulfonat |
| 12 g/l | 3,6-Dithiaoctandiol-1,8 |
| 4 g/l | Bisphenol-A-Ethoxilat (Lutron HF3 der Fa. BASF) |

Die Abscheidung der Zinn-Kupfer-Beschichtung aus diesem Elektrolyten auf einem Kupferblech wurde bei 40 ± 2°C in einer Hochgeschwindigkeitsanlage im Stromdichtebereich von 5-20 A/dm$^2$ durchgeführt. Der Elektrolyt wurde intensiv gerührt (Magnetrührer, 40 mm Rührstab, Rührgeschwindigkeit 700 Upm). Es wurden hellgraue, seidenmatte Abscheidungen erzielt.

Beispiel 3

Der folgende Zinn-Kupfer-Elektrolyt wurde angesetzt:

| | |
|---|---|
| 150 g/l | 70 %ige wässrige Methansulfonsäure |
| 20 g/l | Zinn(II), als Zinnmethansulfonat |
| 0,5 g/l | Kupfer(II), als Kupfermethansulfonat |
| 6 g/l | 3,6-Dithiaoctandiol-1,8 |

In den Elektrolyten, der einen pH von 0 aufwies, wurden 500 g metallische Zinnstücke gegeben, so dass die Oberflächenbeladung 2 dm$^2$/l betrug. Nach einer Standzeit von 24 Stunden bei Raumtemperatur (25 °C) wurde die Abnahme des gelösten Kupfers in der Probe mittels ICP-Emissionsspektrometrie (ICP = inductively coupled plasma) bestimmt. Diese Abnahme ist ein Maß für die Verringerung der Kupferkonzentration im Elektrolyten durch Abscheidung auf dem Zinn (Abscheidung im Ladungsaustausch).

Die Konzentration war um 2 mg/l Kupfer verringert, das entspricht einer Abnahme von 0,4 %.

Vergleichsbeispiel 1

Der gleiche Elektrolyt wie in Beispiel 3 wurde angesetzt, mit der Ausnahme, dass kein 3,6-Dithiaoctandiol-1,8 zugefügt wurde. Die gleiche Menge metallischer Zinnstücke wie in Beispiel 3 wurde zugegeben, so dass ebenfalls eine Oberflächenbeladung von 2 dm$^2$/l resultierte. Eine Messung der Kupferkonzentration mittels ICP-Emissionsspektrometrie nach einer Standzeit von 24 Stunden bei Raumtemperatur (25 °C) ergab eine Verringerung des Kupfergehaltes um 111 mg/l, das entspricht einer Abnahme um 22 %.

Eine Gegenüberstellung des Beispiels 3 und des Vergleichsbeispiels 1 zeigt deutlich, dass der Einsatz der erfindungsgemäßen organischen Schwefelverbindungen eine Abscheidung von Kupfer auf den Zinnanoden im Ladungsaustausch vermeidet und die Kupferkonzentration im Elektrolyten konstant hält.

Beispiel 4

Ein Zinn-Kupfer-Elektrolyt wurde wie folgt angesetzt:

| | |
|---|---|
| 150 g/l | Methansulfonsäure (70 Gew.%) |
| 38,5 g/l | Zinn(II), als Zinn(II)methansulfonat |
| 1 g/l | Kupfer(II), als Kupfer(II)methansulfonat |
| 10 g/l | 3,6-Dithiaoctandiol-1,8 |
| 1 g/l | Brenzcatechin |

Durch ein Volumen von 1 l des genannten Elektrolyten wurde für eine Dauer von 7 Stunden bei 50°C ein Sauerstoffstrom von 80 l/h geleitet. Die folgende Veränderung der Zinn(II)-Konzentration wurde gemessen:

| (1) | Ausgangszustand: | 38,5 g/l Sn(II) |
|---|---|---|
| (2) | nach 7 Stunden Sauerstoffeinleitung:<br>Aussehen der Lösung: gelb, klar | 35,6 g/l Sn(II) |

Beispiel 5

Der folgende Zinn-Kupfer-Elektrolyt wurde angesetzt:

| | |
|---|---|
| 150 g/l | Methansulfonsäure (70 Gew.%) |
| 36,8 g/l | Zinn(II), als Zinn(II)methansulfonat |
| 1 g/l | Kupfer(II), als Kupfer(II)methansulfonat |
| 10 g/l | 3,6-Dithiaoctandiol-1,8 |
| 1 g/l | Brenzcatechin |

Durch ein Volumen von 1 l des genannten Elektrolyten wurde für eine Dauer von 7 Stunden bei 50°C ein Sauerstoffstrom von 80 l/h geleitet. Die folgende Veränderung der Zinn(II)-Konzentration wurde gemessen:

| (1) | Ausgangszustand: | 36,8 g/l Sn(II) |
|---|---|---|
| (2) | nach 7 Stunden Sauerstoffeinleitung:<br>Aussehen der Lösung: gelb, klar | 35,1 g/l Sn(II) |

Die ermittelten Werte zeigen, dass die Oxidation des zweiwertigen Zinns im erfindungsgemäßen Elektrolyten stark reduziert ist.

Vergleichsbeispiel 2

Der Versuch gemäss Beispiel 1 wurde ohne Zugabe von 3,6-Dithiaoctandiol-1,8 wiederholt. Die folgende Veränderung der Zinn(II)-Konzentration wurde gemessen:

| (1) | Ausgangszustand: | 38,5 g/l Sn(II) |
|-----|------------------|-----------------|
| (2) | nach 7 Stunden Sauerstoffeinleitung:<br>Aussehen der Lösung: trüb mit starker Schlammbildung | 23,2 g/l Sn(II) |

Vergleichsbeispiel 3

Der folgende Elektrolyt wurde angesetzt, um zu untersuchen, ob die Zinn(II)oxidation durch Erhöhung der Konzentration der im Stand der Technik bekannten Antioxidantien verhindert werden kann:

| 150 g/l | Methansulfonsäure (70 Gew.%) |
|---------|------------------------------|
| 38,5 g/l | Zinn(II), als Zinn(II)methansulfonat |
| 1 g/l | Kupfer (II), als Kupfer(II)methansulfonat |
| 7 g/l | Brenzcatechin |

Die folgende Veränderung der Zinn(II)-Konzentration wurde gemessen:

| (1) | Ausgangszustand: | 38,5 g/l Sn(II) |
|-----|------------------|-----------------|
| (2) | nach 7 Stunden Sauerstoffeinleitung:<br>Aussehen der Lösung: trüb mit starker Schlammbildung | 24,5 g/l Sn(II) |

Die ermittelten Werte zeigen, dass durch eine Erhöhung der Konzentration des Antioxidationsmittels gemäss dem Stand der Technik auf den siebenfachen Wert der üblicherweise eingesetzten Menge die Zinn(II)oxidation in Gegenwart von Kupferionen nicht verhindert werden kann.

**Patentansprüche**

1.    Saurer wässriger Elektrolyt zur Abscheidung von Zinn-Kupfer-Legierungen umfassend
eine oder mehrere Alkylsulfonsäuren und/oder Alkanolsulfonsäuren,
ein oder mehrere lösliche Zinn(II)salze,
ein oder mehrere lösliche Kupfer(II)salze und
eine oder mehrere organische Schwefelverbindungen,
**dadurch gekennzeichnet, dass** die organischen Schwefelverbindungen als Strukturmerkmal eine oder mehrere Thioetherfunktionen und/oder Etherfunktionen der allgemeinen Formel -R-Z-R'- enthalten, wobei Z jeweils ein Schwefelatom oder ein Sauerstoffatom ist und R und R' gleiche oder verschiedene nichtaromatische organische Reste darstellen, unter der Voraussetzung, dass mindestens einer der Reste R und R' mindestens ein Schwefelatom enthält, wenn Z ausschließlich ein Sauerstoffatom ist.

2.    Elektrolyt gemäß Anspruch 1, **dadurch gekennzeichnet, dass** die organischen Schwefelverbindungen die folgende allgemeine Formel aufweisen:

$$X-R^1-[Z-R^2]_n-Z-R^3-Y \qquad (I)$$

worin n = 0 bis 20 ist, X und Y unabhängig voneinander jeweils -OH, -SH oder -H sind, Z jeweils ein Schwefelatom oder ein Sauerstoffatom darstellt und die Reste Z im Fall $n \geq 1$ gleich oder verschieden sind, $R^1$, $R^2$ und $R^3$ unabhängig voneinander jeweils eine gegebenenfalls substituierte lineare oder verzweigte Alkylengruppe darstellen und die Reste $R^2$ im Fall n > 1 gleich oder verschieden sind, unter der Voraussetzung, dass mindestens einer der Reste X, Y, $R^1$, $R^2$ und $R^3$ mindestens ein Schwefelatom enthält, wenn Z ausschließlich ein Sauerstoffatom ist.

3.    Elektrolyt gemäß Anspruch 2, **dadurch gekennzeichnet, dass** $n \geq 1$ ist, $R^1$, $R^2$ und $R^3$ unabhängig voneinander eine Alkylengruppe, die mindestens zwei Kohlenstoffatome aufweist, darstellen und für den Fall, dass nur ein Z ein Schwefelatom darstellt, X und/oder Y -SH ist und für den Fall, dass Z ausschließlich ein Sauerstoffatom ist, X und Y jeweils -SH sind.

4. Elektrolyt gemäß einem oder mehreren der Ansprüche 1 bis 3, **dadurch gekennzeichnet, dass** das Molverhältnis der organischen Schwefelverbindung zum löslichen Kupfer(II)salz (molare Menge organische Schwefelverbindung : molare Menge lösliches Kupfer(II)salz) mindestens 2:1 beträgt.

5. Elektrolyt gemäß einem oder mehreren der Ansprüche 1 bis 4, **dadurch gekennzeichnet, dass** die Zinn(II)salze die Salze von Mineral-, Alkylsulfon- oder Alkanolsulfonsäuren sind.

6. Elektrolyt gemäß einem oder mehreren der Ansprüche 1 bis 5, **dadurch gekennzeichnet, dass** die Kupfer(II) salze die Salze von Mineral-, Alkylsulfon- oder Alkanolsulfonsäuren sind.

7. Elektrolyt gemäß einem oder mehreren der Ansprüche 1 bis 6, **dadurch gekennzeichnet, dass** ein kornverfeinernder Zusatz enthalten ist.

8. Elektrolyt gemäß Anspruch 7, **dadurch gekennzeichnet, dass** als kornverfeinernder Zusatz nichtionogene Tenside der allgemeinen Formel RO-(CH$_2$CH$_2$-O)$_n$-H, worin R eine Alkyl-, Aryl-, Alkaryl- oder Aralkylgruppe darstellt und n = 1 bis 20 ist, vorliegen.

9. Verfahren zur elektrolytischen Beschichtung von Substraten mit Zinn-Kupfer-Legierungen, **dadurch gekennzeichnet, dass** die Beschichtung unter Durchleiten von Gleichstrom unter Einsatz eines Elektrolyten gemäß einem der Ansprüche 1 bis 8, einer Anode aus metallischem Zinn und einer Kathode aus dem zu beschichtenden Substrat durchgeführt wird.

10. Verwendung des Elektrolyten gemäß einem der Ansprüche 1 bis 8 zur Beschichtung von elektronischen Bauteilen.

## Claims

1. Acid aqueous electrolyte for deposition of tin-copper alloys comprising one or more alkyl sulphonic acids and/or alkanol sulphonic acids, one or more soluble tin(II) salts, one or more soluble copper(II) salts and one or more organic sulphur compounds, **characterised in that** the organic sulphur compounds contain as a structural feature, one or more thioether functions and/or ether functions of the general formula -R-Z-R'-, wherein Z is in each case a sulphur atom or an oxygen atom and R and R' represent the same or different non-aromatic organic radicals, under the assumption that at least one of the radicals R and R' contains at least one sulphur atom, if Z is exclusively an oxygen atom.

2. Electrolyte according to claim 1, **characterised in that** the organic sulphur compounds have the following general formula:

$$X\text{-}R^1\text{-}[Z\text{-}R^2]_n\text{-}Z\text{-}R^3\text{-}Y \qquad\qquad (I)$$

wherein n = 0 to 20, X and Y independently of one another are in each case -OH, -SH or -H, Z represents in each case a sulphur atom or an oxygen atom and the radicals Z in the case $n \geq 1$ are the same or different, $R^1$, $R^2$ and $R^3$ independently of one another represent in each case an optionally substituted linear or branched alkylene group and the radicals $R^2$ in the case n > 1 are the same or different, under the assumption that at least one of the radicals X, Y, $R^1$, $R^2$ and $R^3$ contains at least one sulphur atom, if Z is exclusively an oxygen atom.

3. Electrolyte according to claim 2, **characterised in that** $n \geq 1$, $R^1$, $R^2$ and $R^3$ independently of one another represent an alkylene group which has at least two carbon atoms, and for the case that only one Z represents a sulphur atom, X and/or Y is -SH and for the case that Z is exclusively an oxygen atom, X and Y are in each case -SH.

4. Electrolyte according to one or more of claims 1 to 3, **characterised in that** the molar ratio of the organic sulphur compound to the soluble copper(II) salt (molar quantity of organic sulphur compound : molar quantity of soluble copper(II) salt) is at least 2:1.

5. Electrolyte according to one or more of claims 1 to 4, **characterised in that** the tin(II) salts are the salts of mineral acids, alkyl sulphonic acids or alkanol sulphonic acids.

6. Electrolyte according to one or more of claims 1 to 5, **characterised in that** the copper(II) salts are the salts of mineral acids, alkyl sulphonic acids or alkanol sulphonic acids.

7. Electrolyte according to one or more of claims 1 to 6, **characterised in that** a grain-refining additive is present.

8. Electrolyte according to claim 7, **characterised in that** non-ionic surfactants of the general formula $RO-(CH_2CH_2-O)_n-H$, wherein R represents an alkyl, aryl, alkaryl or aralkyl group and n = 1 to 20, are present as the grain-refining additive.

9. Process for the electrolytic coating of substrates with tin-copper alloys, **characterised in that** coating is carried out while conducting direct current using an electrolyte according to one of claims 1 to 8, an anode made from metallic tin and a cathode made from the substrate to be coated.

10. Use of the electrolyte according to one of claims 1 to 8 for coating electronic components.


**Revendications**

1. Electrolyte aqueux acide pour la déposition d'alliages étain-cuivre, comprenant :

   un ou plusieurs acides alkylsulfoniques et/ou
   des acides alkanolsulfoniques,
   un ou plusieurs sels d'étain (II) solubles,
   un ou plusieurs sels de cuivre (II) solubles, et
   un ou plusieurs composés soufrées organiques,

   **caractérisé en ce que** les composés soufrés organiques contiennent, en tant que caractéristique structurelle, une ou plusieurs fonctions thioéther et/ou des fonctions éther de la formule générale -R-Z-R'-, dans laquelle Z est chaque fois un atome de soufre ou un atome d'oxygène, et R et R' sont des résidus organiques non aromatiques, identiques ou différents, sous l'hypothèse selon laquelle au moins l'un des résidus R et R' contient au moins un atome de soufre, lorsqué Z est exclusivement un atome d'oxygène.

2. Electrolyte selon la revendication 1, **caractérisé en ce que** les composés soufrés organiques présentent la formule générale suivante :

$$X-R^1-[Z-R^2]_n-Z-R^3-Y \tag{I}$$

   dans laquelle n = 0 à 20, X et Y sont, indépendamment l'une de l'autre, chaque fois -OH, -SH ou -H, Z est chaque fois un atome de soufre ou un atome d'oxygène, et les résidus Z, dans le cas où $n \geq 1$, sont identiques ou différents, $R^1$, $R^2$ et $R^3$ étant, indépendamment les uns des autres chacun un groupe alkyl linéaire ou ramifié, le cas échéant substitué, et les résidus $R^2$, dans le cas où n > 1, étant identiques ou différents, sous l'hypothèse selon laquelle au moins l'un des résidus X, Y, $R^1$, $R^2$ et $R^3$ contient au moins un atome de soufre, lorsque Z est exclusivement un atome d'oxygène.

3. Electrolyte selon la revendication 2, **caractérisé en ce que** $n \geq 1$, $R^1$, $R^2$ et $R^3$, indépendamment les uns des autres représentent un groupe alkylène, présentant au moins deux atomes de carbone, et, dans le cas où seul un Z constitue un atome de soufre, X et/ou Y est -SH et, dans le cas où Z est exclusivement un atome d'oxygène, X et Y sont chacun -SH.

4. Electrolyte selon une ou plusieurs des revendications 1 à 3, **caractérisé en ce que** le rapport molaire du composé soufré organique, par rapport au sel de cuivre (II) soluble (quantité molaire du composé soufré organique : quantité molaire de sel de cuivre (II) soluble), est d'au moins 2 :1.

**5.** Electrolyte selon une ou plusieurs des revendications 1 à 4, **caractérisé en ce que** les sels d'étain (II) sont les sels d'acides minéraux, d'acides alkylsulfoniques ou alkanolsulfoniques.

**6.** Electrolyte selon une ou plusieurs des revendications 1 à 5, **caractérisé en ce que** les sels de cuivre (II) sont les sels d'acides minéraux, d'acides alkylsulfonique ou alkanolsulfonique.

**7.** Electrolyte selon une ou plusieurs des revendications 1 à 6, **caractérisé en ce qu'**un additif, affinant les grains, est contenu.

**8.** Electrolyte selon la revendication 7, **caractérisé en ce que** sont présents comme additif affinant les grains des tensioactifs non ionogènes, de formule générale $RO-(CH_2CH_2-O)_n-H$, dans laquelle R représente un groupe alkyl, aryl, alkaryl ou aralkyl et n = 1 à 20.

**9.** Procédé de revêtement électrolytique de substrats avec des alliages étain-cuivre, **caractérisé en ce que** l'application d'un revêtement est effectuée en faisant passer un courant continu, avec utilisation d'un électrolyte selon l'une des revendications 1 à 8, d'une anode en étain métallique et d'une cathode formée du substrat à revêtir.

**10.** Utilisation de l'électrolyte selon une des revendications 1 à 8, pour revêtir des composants électroniques.